# EUROPEAN PATENT SPECIFICATION

(11) **EP 0 488 160 B1**
(45) Date of publication and mention of the grant of the patent: **07.02.1996**
(21) Application number: 91120174.7
(22) Date of filing: 26.11.1991
(51) Int. Cl.: H03F 3/60, H01L 23/48

(54) **Multistage amplifier**
Mehrstufiger Verstärker
Amplificateur multi étage

(30) Priority: 27.11.1990 JP 323725/90
(43) Date of publication of application: 03.06.1992
(73) Proprietor: Sumitomo Electric Industries, Ltd., Osaka 541 (JP)
(72) Inventor: Shiga, Nobuo, c/o Yokohama Works, Yokohama-shi, Kanagawa (JP)
(74) Representative: Grünecker, Kinkeldey, Stockmair & Schwanhäusser Anwaltssozietät

(56) References cited:
- FR-A- 2 618 947
- US-A- 3 969 745
- MICROWAVE JOURNAL. vol. 25, no. 3, March 1982, DEDHAM US pages 51 - 66; J.M. SCHELLENBERG ET AL: 'A New Approach to FET Power Amplifiers'

## Description

The present invention relates to a multistage amplifier according to the preamble of claim 1.

### 2. Description of Related Art

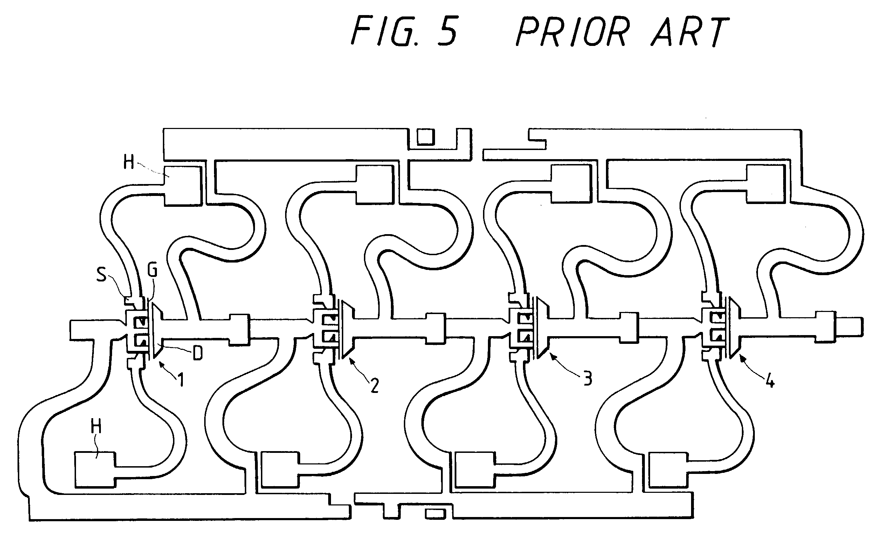

A wiring pattern of a conventional multistage FET amplifier on a semiconductor substrate is shown in FIG. 5 (Prior Art). This is the pattern that is revealed in FIG. 7 of the paper entitled "X-Band Monolithic Four-Stage LNA with Pulse-doped GaAs MESFETs" in the document "GaAs IC Symposium Tech. Digest, 1990."

This prior art multistage FET amplifier is a four-stage amplifier in which four FETs 1 through 4 are connected to each other in four stages. Each of the FETs 1 through 4 is provided with a source electrode S, a drain electrode D, and a gate electrode G. The four FETs are monolithically formed on one semiconductor substrate. A lengthy wiring pattern is repeated in the prior art, as shown in FIG. 5 (Prior Art), between each FET, so that a multistage connection is formed from the first stage FET 1 through the final stage FET 4.

A second conventional construction of a multistage FET amplifier is an arrangement of a plurality of FETs in a single integrated circuit (IC) package with external FET interconnection wiring. A third arrangement exists in which a plurality of FETs, formed independently of each other in separate IC packages, are utilized and externally wired to constitute a multistage FET amplifier.

Each of the conventional multistage FET amplifiers revealed by prior art has problems. The multistage FET amplifier monolithically formed on a semiconductor substrate, as shown in FIG. 5, is relatively large in size. The size of the multistage amplifier is directly linked to the area occupied by wiring patterns and the number of via- holes used. Each of the FETs 1 through 4 has two wiring patterns connected to its source electrode S and each of these wiring patterns is connected to a separate and distinct via- hole H. Accordingly, the area occupied with the wiring patterns on the semiconductor substrate is large and the number of via- holes required is great. This has an adverse effect on the size of the multistage amplifier and on the manufacturing yield.

The conventional multistage FET amplifier that comprises a plurality of FETs contained in a single IC package and external FET interconnection wiring also has problems. The external wiring that is required for this multistage amplifier considerably adds to its size and decreases the manufacturer's efficiency.

A conventional multistage FET amplifier constituted by using a plurality of FETs in independent IC packages is larger than a monolithically formed multistage FET amplifier. These multistage amplifiers have an additional problem. Scattering is introduced into the multistage amplifier because the characteristics of the FETs are different, as they were manufactured independently. Accordingly, the characteristics of such a multistage amplifier are unstable.

The following documents also show multistage amplifiers formed on a first surface of a semiconductor substrate and using via-holes passing through the substrate to its back surface for connecting one electrode of each transistor of the multistage amplifier with a common grounded conductor on said back surface. In Microwave Journal, Vol. 25, No. 3, March 1982, Dedham, US, pages 51 to 56, J. M. Schellenberg et al, "A New Approach to FET Power Amplifiers" show a two transistor amplifier comprising two via-holes located on either side of the amplifier unit cell.

US-A-3969745 teaches to use a via-hole for each source electrode of the plurality of the transistors constitutina a multistage amplifier, with the via-holes essentially being arranged along a straight line.

FR-A-2618947 indicates that the fabrication of a plurality of via-holes located closely to each other could cause problems in the manufacturing and reliability of the device, which, therefore, teaches to diagonally shift adjacent via-holes with respect to each other.

### SUMMARY OF THE INVENTION

The present invention has been attained in order to solve the problems of large size, low manufacturing yield, poor manufacturing efficiency, and instability caused by scattering as seen in the prior art. The object of the invention is to provide a multistage amplifier overcoming the above problems.

According to the invention, this object is solved by a multistage amplifier having the features as set out in claim 1.

According to the invention, the transistors are monolithically formed around a central via-hole. Predetermined electrodes of the various transistors are electrically connected to each other in the area immediately surrounding the central via-hole.

The distance between the area immediately surrounding the central via-hole and the predetermined electrode of each of the transistors is minimal. The wiring patterns between the predetermined electrodes and the area immediately surrounding the central via- hole is thereby kept minimal. Since the electrodes are electrically connected to each other in the area surrounding the central via-hole, the number of via- holes required is minimal.

Further, since the transistors are monolithically formed in the same manufacturing process, no scattering is caused in the characteristics of the transistors. This increases the multistage amplifier's stability.

### BRIEF DESCRIPTION OF THE DRAWINGS

FIG. 1 is a view of a wiring pattern of the two-stage amplifier which is the first embodiment of the present invention;
FIG. 2 is an equivalent circuit diagram of the two-stage amplifier shown in FIG. 1;
FIG. 3 is a view of a wiring pattern of the four-stage amplifier which is the second embodiment of the present invention;
FIG. 4 is an equivalent circuit diagram of the four-stage amplifier shown in FIG. 3; and
FIG. 5 (Prior Art) is a view of a wiring pattern of a conventional four-stage FET amplifier.

### DETAILED DESCRIPTION OF THE PREFERRED EMBODIMENTS

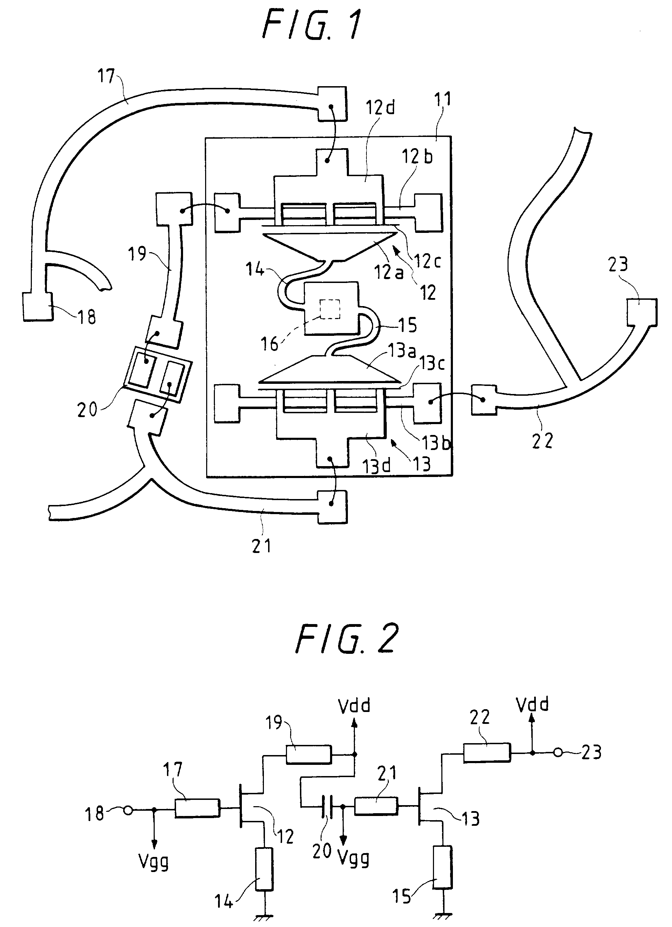

The first embodiment of the present invention comprises a multistage amplifier, as shown in the wiring pattern diagram of FIG. 1. The multistage amplifier of this embodiment is constituted by two MESFETs (Schottky gate-type FETs) 12 and 13 formed on a single semiconductor chip 11. The FETs 12 and 13 are monolithically formed in opposition to each other around a central via- hole 16 on the semiconductor chip 11. The FETs 12 and 13 are provided with source electrodes 12a and 13a, drain electrodes 12b and 13b, and gate electrodes 12c and 13c, respectively. The source electrodes 12a and 13a are electrically connected to each other in the area immediately surrounding the central via- hole 16 of the semiconductor chip 11 through source stubs 14 and 15 respectively. Further, the connection portion is electrically connected, through the via- hole 16, to a grounding pattern formed on the back surface of the semiconductor chip 11.

Although the source stubs 14 and 15 act as series feedback circuits in the amplification operation of the FETs 12 and 13 respectively, and are important for realizing a narrow-band amplifier, they are not always required. The source electrodes 12a and 13a may be connected directly to the via-hole 16 without providing the respective source stubs 14 and 15.

The semiconductor chip 11 is mounted on a ceramic substrate, and the FETs 12 and 13 are multi-connected to each other through wiring patterns formed on the ceramic substrate. By this multi-stage connection, a two-stage amplifier is formed as shown in the equivalent circuit in FIG. 2. A micro strip line 17 is connected through a bonding wire to a gate wire pattern 12d, which is connected to the gate electrode 12c of the FET 12. An input pad 18 to which an external input signal is applied is formed at one end of the micro strip line 17. As previously described, the source electrode 12a of the FET 12 is grounded through the source stub 14. The drain electrode 12b of the FET 12 is connected to a micro strip line 19 through a bonding wire. The micro strip line 19 is connected through a bonding wire to one electrode of a chip capacitor 20.

The other electrode of the chip capacitor 20 is connected to a micro strip line 21 through a bonding wire. The other end of the micro strip line 21 is connected through a bonding wire to a gate wiring pattern 13d of the FET 13, which is connected to the gate electrode 13c. As previously described, the source electrode 13a of the FET 13 is grounded through the source stub 15. The drain electrode 13b of the FET 13 is connected to a micro strip line 22 through a bonding wire. The micro strip line 22 is connected to an output pad 23 to which an amplified output signal of the multistage amplifier is supplied.

A power supply circuit pattern for supplying a power source to each of the FETs 12 and 13 is omitted from FIG. 1. There is a wiring pattern for supplying a power source Vgg to each of the gate electrodes 12c and 13c, and a wiring pattern for supplying a power source Vdd to each of the drain electrodes 12b and 13b.

In the two-stage amplifier of this embodiment, an impedance matching circuit is formed on the ceramic substrate, and the semiconductor chip 11 is mounted on the ceramic substrate. The FETs 12 and 13 on the semiconductor chip 11 are monolithically formed in one and the same manufacturing process, so that no scattering is caused in the characteristics of the FETs 12 and 13. Accordingly, the characteristics of the thus obtained multistage amplifier are stable.

The FETs 12 and 13 are formed around a central via- hole. The distance between the area immediately surrounding the central via- hole, where the source electrodes 12a and 13a are electrically connected to each other, and the source electrodes 12a and 13a is minimal. Accordingly, the wiring pattern of each of the source electrodes is minimal, the wiring pattern area of the whole multistage amplifier is minimized, and the size of the amplifier is reduced. Also the requirement of only one via- hole 16 which makes it possible to ground the source electrodes 12a and 13a increases manufacturing yield.

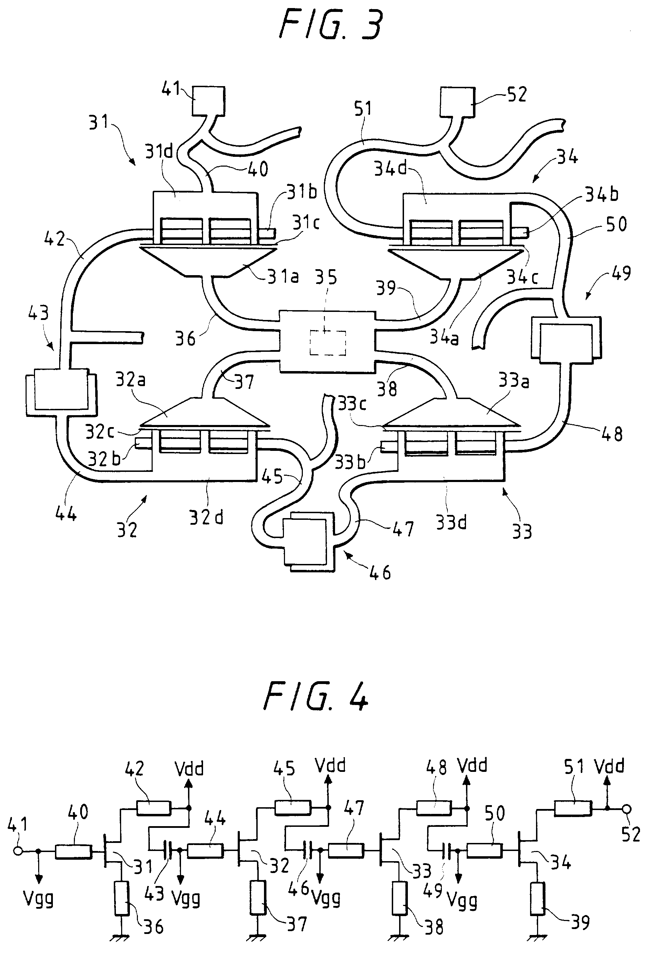

The second embodiment of the present invention is a wiring pattern of a multistage amplifier as shown in FIG. 3. The multistage amplifier of this embodiment is a four-stage amplifier structure. This multistage amplifier comprises four MESFETs 31 through 34 and an impedance matching circuit which are formed on one and the same semiconductor substrate. The FETs 31 through 34 are monolithically formed around a central via- hole 35. As in the first embodiment, the FETs 31 through 34 have source electrodes 31a through 34a, drain electrodes 31b through 34b, and gate electrodes 31c through 34c, respectively.

The FETs 31 through 34 are connected to each other in a manner to form a four-stage amplifier as shown in the equivalent circuit of FIG. 4. The source electrodes 31a through 34a are electrically connected to each other in the area immediately surrounding the central via- hole 35 through source stubs 36 through 39, respectively. This area is electrically connected through the via- hole 35 to a grounding pattern formed on the back surface of the semiconductor substrate.

Although the source stubs 36 through 39 act as series feedback circuits in the amplification operation of the FETs 31 through 34 respectively, and are important for realizing a narrow-band amplifier, they are not always required. The source electrodes 31a, 32a, 33a, and 34a may be connected directly to the via- hole 35 without providing the respective source stubs 36 through 39.

In the four-stage amplifier of the second embodiment a micro strip line 40 is connected to a gate wiring pattern 31d, which is connected to the gate electrode 31c of the FET 31. An input pad 41 to which an external input signal is supplied is formed on one end of the micro strip line 40. The drain electrode 31b of the FET 31 is connected to a micro strip line 42. The micro strip line 42 is connected to one electrode of a MIM (Metal-Insulator-Metal) capacitor 43.

The other electrode of the MIM capacitor 43 is connected to a micro strip line 44. The other end of the micro strip line 44 is connected to a gate wiring pattern 32d of the FET 32, which is connected to the gate electrode 32c. The drain electrode 32b of the FET 32 is connected to a micro strip line 45. The micro strip line 45 is connected to one electrode of an MIM capacitor 46.

The other electrode of the MIM capacitor 46 is connected to a micro strip line 47. The other end of the micro strip line 47 is connected to a gate wiring pattern 33d of the FET 33, which is connected to the gate electrode 33c. The drain electrode 33b of the FET 33 is connected to a micro strip line 48. The micro strip line 48 is connected to one electrode of an MIM capacitor 49.

The other electrode of the MIM capacitor 49 is connected to a micro strip line 50. The other end of the micro strip line 50 is connected to a gate wiring pattern 34d of the FET 34, which is connected to the gate electrode 34c. The drain electrode 34b of the FET 34 is connected to an output pad 52 through a micro strip line 51. An amplified signal from the multistage amplifier is supplied to the output pad 52.

A power supply circuit pattern for supplying a power source to each of the FETs 31 through 34 is omitted from FIG. 3.

In a four-stage amplifier of this embodiment, the FETs 31 through 34 are monolithically formed on one and the same semiconductor substrate in one and the same manufacturing process. Accordingly, no scattering is present in the characteristics of the FETs and the multistage amplifier is stable.

Since the FETs 31 through 34 are formed around the via-hole 35, the distance between the area immediately surrounding the via- hole 35, where the source electrodes of the FETs 31a through 34a are electrically connected and each of the source electrodes 31a through 34a is minimal. Accordingly, the wiring pattern of each of the source electrode portions is minimal and the wiring pattern area of the whole multistage amplifier is minimized. As a result, the size of the amplifier is reduced as in the first embodiment. Also the requirement of only one via- hole 35 which makes it possible to ground the source electrodes 31a through 34a increases manufacturing yield as in the first embodiment.

## Claims

1. A multistage amplifier comprising:
a plurality of transistors (12, 13) for multistage amplifying an input signal so as to output an amplified signal, said transistors (12, 13) being monolithically integrated on a first surface of a single substrate (11)
**characterized in that**
a single centrally located via-hole (16) formed in said substrate is provided for connecting one of the electrodes of each transistor to a second surface of said substrate through said via-hole wherein the plurality of transistors (12, 13) is arranged such as to jointly use said single via-hole (16).

2. A multistage amplifier as claimed in claim 1, further comprising an impedance matching circuit.

3. A multistage amplifier as claimed in claim 1 or 2, wherein predetermined electrodes (12a, 13a) of said transistors (12, 13) are electrically connected to each other in an area immediately surrounding said central via-hole (16).

4. A multistage amplifier as claimed in claim 1 or 2, wherein source electrodes (12a, 13a) of said transistors (12, 13) are electrically connected to each other in an area immediately surrounding said central via-hole (16).

5. A multistage amplifier as claimed in claim 1 comprising two transistors (12, 13) for two stage amplifying.

6. A multistage amplifier as claimed in claim 5 further comprising an impedance matching circuit.

7. A multistage amplifier as claimed in claim 5 or 6, wherein predetermined electrodes (12a, 13a) of said transistors (12, 13) are electrically connected to each other in an area immediately surrounding said central via-hole (16).

8. A multistage amplifier as claimed in claim 5 or 6, wherein source electrodes (12a, 13a) of said transistors (12, 13) are electrically connected to each other in an area immediately surrounding said central via-hole (16).

9. A multistage amplifier as claimed in claim 1 comprising four transistors (31, 32, 33, 34) for four-stage amplifying.

10. A multistage amplifier as claimed in claim 9 further comprising an impedance matching circuit.

11. A multistage amplifier as claimed in claim 9 or 10, wherein predetermined electrodes (31a, 32a, 33a, 34a) of said transistors are electrically connected to each other in an area immediately surrounding said central via-hole (16).

12. A multistage amplifier as claimed in claim 9 or 10, wherein source electrodes (31a, 32a, 33a, 34a) of said transistors are electrically connected to each other in an area immediately surrounding said central via-hole (16).

## Patentansprüche

1. Ein mehrstufiger Verstärker mit:
einer Vielzahl von Transistoren (12, 13) zum mehrstufigen Verstärken eines Eingangssignals und zur Ausgabe eines verstärkten Signals, wobei die Transistoren (12, 13) monolithisch auf einer ersten Oberfläche eines einzigen Substrats (11) integriert sind,
**dadurch gekennzeichnet, daß**
ein einziges, zentral gelegenes Durchtrittsloch (16), das in dem Substrat ausgebildet ist, zum Verbinden einer Elektrode eines jeden Transistors mit einer zweiten Oberfläche des Substrats durch das Durchtrittsloch hindurch vorgesehen ist, wobei die Vielzahl von Transistoren (12, 13) derart angeordnet ist, daß sie gemeinsam das einzige Durchtrittsloch (16) verwenden.

2. Ein mehrstufiger Verstärker nach Anspruch 1, der weiter einen Impedanz anpassenden Schaltkreis umfaßt.

3. Ein mehrstufiger Verstärker nach Anspruch 1 oder 2, wobei vorbestimmte Elektroden (12a, 13a) der Transistoren (12, 13) elektrisch miteinander in einem unmittelbar das zentrale Durchtrittsloch (16) umgebenden Gebiet verbunden sind.

4. Ein mehrstufiger Verstärker nach Anspruch 1 oder 2, wobei die Sourceelektroden (12a, 13a) der Transistoren (12, 13) in einem unmittelbar das zentrale Durchtrittsloch (16) umgebenden Gebiet elektrisch miteinander verbunden sind.

5. Ein mehrstufiger Verstärker nach Anspruch 1, der zwei Transistoren (12, 13) zur zweistufigen Verstärkung umfaßt.

6. Ein mehrstufiger Verstärker nach Anspruch 5, der weiter einen Impedanz anpassenden Schaltkreis umfaßt.

7. Ein mehrstufiger Verstärker nach Anspruch 5 oder 6, wobei vorbestimmte Elektroden (12a, 13a) der Transistoren (12,13) elektrisch miteinander in einem unmittelbar das zentrale Durchtrittsloch (16) umgebenden Gebiet verbunden sind.

8. Ein mehrstufiger Verstärker nach Anspruch 5 oder 6, wobei die Sourceelektroden (12a, 13a) der Transistoren (12, 13) in einem unmittelbar das zentrale Durchtrittsloch (16) umgebenden Gebiet elektrisch miteinander verbunden sind.

9. Ein mehrstufiger Verstärker nach Anspruch 1, der vier Transistoren (31, 32, 33, 34) zur vierstufigen Verstärkung umfaßt.

10. Ein mehrstufiger Verstärker nach Anspruch 9, der weiter einen Impedanz anpassenden Schaltkreis umfaßt.

11. Ein mehrstufiger Verstärker nach Anspruch 9 oder 10, wobei vorbestimmte Elektroden (31a, 32a, 33a, 34a) der Transistoren in einem unmittelbar das zentrale Durchtrittsloch (16) umgebenden Gebiet elektrisch miteinander verbunden sind.

12. Ein mehrstufiger Verstärker nach Anspruch 9 oder 10, wobei Sourceelekroden (31a, 32a, 33a, 34a) der Transistoren in einem unmittelbar das zentrale Durchtrittsloch (16) umgebenden Gebiet elektrisch miteinander verbunden sind.

## Revendications

1. Amplificateur à plusieurs étages comprenant une pluralité de transistors (12, 13) pour une amplification sur plusieurs étages d'un signal d'entrée de façon à générer un signal amplifié, lesdits transistors (12, 13) étant intégrés, de façon monolithique, à une première surface d'un support unique (11),
amplificateur caractérisé en ce qu'un seul trou traversant placé de façon centrale (16), formé dans ledit support, est prévu pour raccorder une des électrodes de chaque transistor à une seconde surface dudit support via ledit trou traversant, amplificateur dans lequel la pluralité de transistors (12, 13) est agencée de façon à utiliser conjointement ledit trou traversant unique (16).

2. Amplificateur à plusieurs étages selon la revendication 1, comprenant, de plus, un circuit d'adaptation d'impédance.

3. Amplificateur à plusieurs étages selon la revendication 1 ou 2, dans lequel des électrodes prédéterminées (12a, 13a) desdits transistors (12, 13) sont raccordées, de façon électrique, l'une à l'autre dans une zone entourant immédiatement ledit trou traversant central (16).

4. Amplificateur à plusieurs étages selon la revendication 1 ou 2, dans lequel les électrodes de source (12a, 13a) desdits transistors (12, 13) sont raccordées, de façon électrique, l'une à l'autre dans une zone entourant immédiatement ledit trou traversant central (16).

5. Amplificateur à plusieurs étages selon la revendication 1, comprenant deux transistors (12, 13) pour une amplification à deux étages.

6. Amplificateur à plusieurs étages selon la revendication 5, comprenant, de plus, un circuit d'adaptation d'impédance.

7. Amplificateur à plusieurs étages selon la revendication 5 ou 6, dans lequel des électrodes prédéterminées (12a, 13a) desdits transistors (12, 13) sont raccordées, de façon électrique, l'une à l'autre dans une zone entourant immédiatement ledit trou traversant central (16).

8. Amplificateur à plusieurs étages selon la revendication 5 ou 6, dans lequel des électrodes de source (12a, 13a) desdits transistors (12, 13) sont raccordées, de façon électrique, l'une à l'autre dans une zone entourant immédiatement ledit trou traversant central (16).

9. Amplificateur à plusieurs étages selon la revendication 1, comprenant quatre transistors (31, 32, 33, 34) pour une amplification à quatre étages.

10. Amplificateur à plusieurs étages selon la revendication 9, comprenant, de plus, un circuit d'adaptation d'impédance.

11. Amplificateur à plusieurs étages selon la revendication 9 ou 10, dans lequel des électrodes prédéterminées (31a, 32a, 33a, 34a) desdits transistors (12, 13) sont raccordées, de façon électrique, l'une à l'autre dans une zone entourant immédiatement ledit trou traversant central (16).

12. Amplificateur à plusieurs étages selon la revendication 9 ou 10, dans lequel des électrodes de source (31a, 32a, 33a, 34a) desdits transistors sont raccordées, de façon électrique, l'une à l'autre dans une zone entourant immédiatement ledit trou traversant central (16).
